# EUROPEAN PATENT SPECIFICATION

(11) **EP 3 072 680 B1**
(45) Date of publication and mention of the grant of the patent: **06.11.2019**
(21) Application number: 16153597.6
(22) Date of filing: 01.02.2016
(51) Int. Cl.: B32B 5/26, B32B 9/04

(54) **HIGH THERMAL CONDUCTIVITY COMPOSITE BASE PLATE AND OUTPUT MULTIPLEXER CHASSIS**
VERBUNDGRUNDPLATTE MIT HOHER WÄRMELEITFÄHIGKEIT UND AUSGANGSMULTIPLEXERGEHÄUSE
PLAQUE DE BASE DE COMPOSITE À CONDUCTIVITÉ THERMIQUE ÉLEVÉE ET CHÂSSIS DE MULTIPLEXEUR DE SORTIE

(30) Priority: 23.03.2015 US 201514666241
(43) Date of publication of application: 28.09.2016
(73) Proprietor: The Boeing Company, Chicago, IL 60606-1596 (US)
(72) Inventor: ASTON, Richard William, Chicago, IL Illinois 60606-2016 (US); TOMZYNSKA, Anna Maria, Chicago, IL Illinois 60606-2016 (US)
(74) Representative: Boult Wade Tennant LLP

(56) References cited:
- US-A- 5 554 430
- US-A1- 2014 154 456

## Description

### BACKGROUND

### 1. Field

Various embodiments described herein are related to spacecraft thermal control systems and, more particularly, to base plates utilizing heat-pipes.

### 2. Related Art

Spacecraft include a plethora of equipment, such as electronic equipment, that generates heat. This heat must be dissipated, and because space is essentially void of air, the heat must be radiated to outer space. Spacecraft, such as satellites, typically include a spacecraft thermal control system that draws the heat from electronics and other equipment in the spacecraft to an outer surface of the spacecraft.

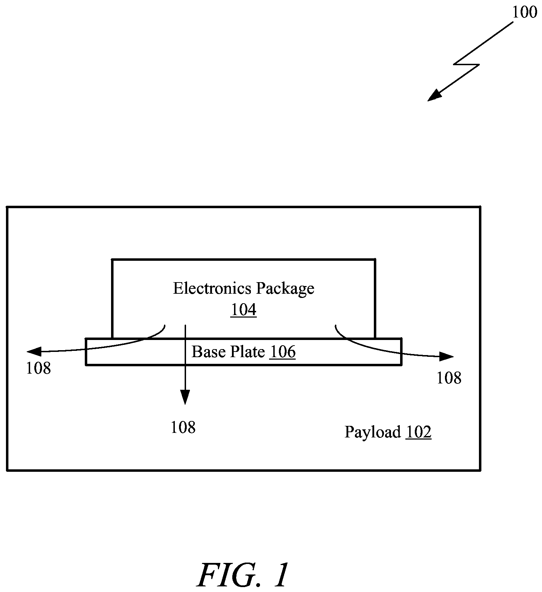

In FIG. 1, a system diagram of an example of an implementation of a typical known spacecraft 100 payload 102 is shown. The payload 102 includes a plurality of devices, modules, and/or components (generally referred to as an "electronics packages") that generate heat. These electronics packages may be active or passive devices but in general all the electronics packages generate heat that needs to be transferred out of the payload 102 and generally to the external environment outside of the spacecraft 100.

In this example, the payload 102 may include an electronics package 104 that is physically connected and thermally coupled to a base plate 106. In general, the base plate 106 is constructed of metal such as, for example, aluminum. The function of the base plate 106 is to structurally support the electronics package 104 and conduct dissipated heat 108 from the electronics package 104 to a thermal heat-pipe (not shown) that is thermally coupled to the base plate 106. It is appreciated by those of ordinary skill in the art that instead of just one electronics package 104, the base plate 106 usually has a plurality of electronic packages physically connected to the base plate 106.

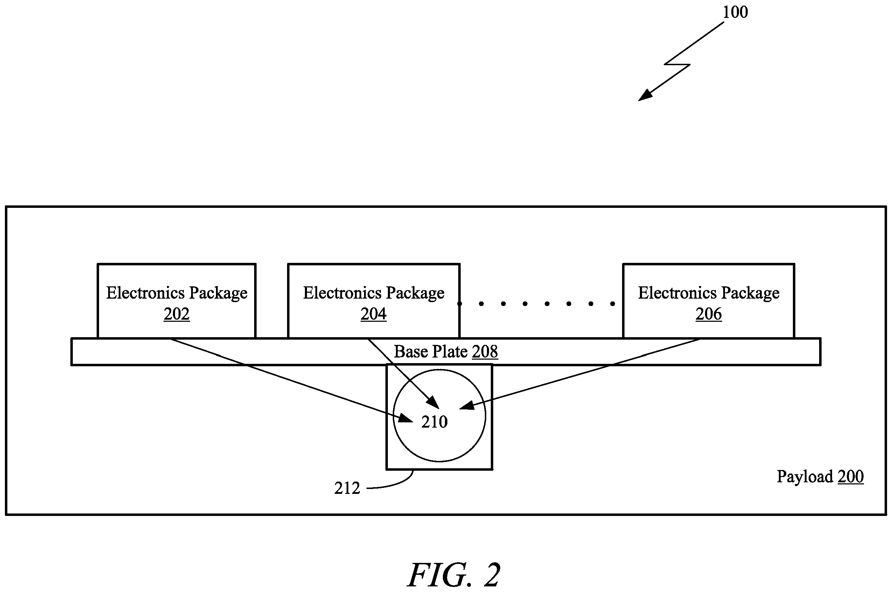

Turning to FIG. 2, a system diagram of an example of another implementation of a typical known spacecraft 100 payload 200 is shown. In this example, the payload 200 includes a plurality of electronic packages 202, 204, and 206, respectively, physically connected and thermally coupled to a base plate 208. Again, these electronics packages 202, 204, and 206 may be active or passive devices but in general all the electronics packages 202, 204, and 206 generate heat that is transferred to the base plate 208 and needs to be transferred out of the payload 200 and generally to the external environment outside of the spacecraft 100.

As in the example shown in FIG. 1, in general, the base plate 208 is constructed of metal such as, for example, aluminum. The function of the base plate 200 is to structurally support the electronics packages 202, 204, and 206 and conduct dissipated heat 210 from the electronics packages 202, 204, and 206 to one or more thermal heat-pipes that are thermally coupled to the base plate 208. In this example, one thermal heat-pipe 212 is shown for the purpose of illustration but it is appreciated by those of ordinary skill in the art that there may be a plurality of heat-pipes thermally coupled to the base plate 208.

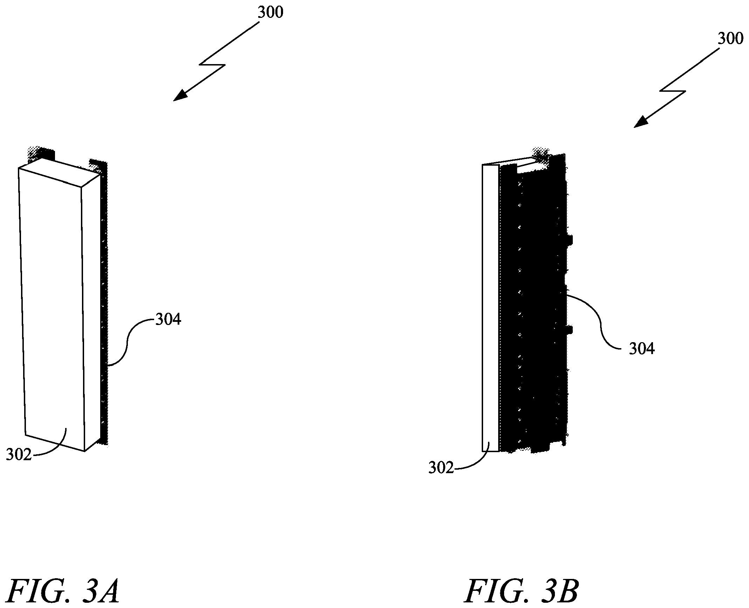

In FIG. 3A, a top perspective-view of an example of an implementation of a known output multiplexer chassis 300 is shown. Similarly in FIG. 3B, a bottom perspective-view of the known output multiplexer chassis 300 is shown. The output multiplexer chassis 300 may include an output multiplexer 302 and a base plate 304 connected to the output multiplexer 302. The output multiplexer 302 is an example of an electronics package as described in FIGs. 1 and 2. In this example, the output multiplexer 302 may be a passive microwave or millimeter waveguide network having a plurality of metallic waveguide runs and couplers that radiate heat when power is transmitted through the network. In general, the output multiplexer 302 needs to be structurally supported and as such the base plate 304 needs to provide the structural support that the output multiplexer 302 physically needs. As such, the base plate 304 needs to be constructed from a structurally strong material, or materials, so as to provide the physical strength and rigidity needed to support and protect the output multiplexer 302. Additionally, since the output multiplexer 302 generates and dissipates a significant amount of heat, the base plate 304 needs to be constructed from a material, or materials, that is also a good heat conductor capable of transferring the heat generated by the output multiplexer 302 to a heat-pipe (not shown) that is capable of transferring the heat away from the payload. In this example, the heat-pipe may be located at a long-edge of the base plate 304. This example is based on a known output multiplexer chassis of a Boeing 702SP satellite system.

In order to meet both the structural and thermal needs of the output multiplexer 302 (or other similar types of electronics packages), the known base plate 302 is made of metal such as, for example, 0.43 cm (0.170 inch) thick aluminum. Unfortunately, metal (even aluminum) is relatively heavy and for aircraft or spacecraft the weight of the base plate 302 limits how many electronics packages may be included in a payload. As an example, a typical aluminum base plate in a known output multiplexer chassis (such as, for example, a Boeing 702SP satellite system) may weigh approximately 4.76 kg (10.5 pounds).

US 2014/0154456 discloses a carbon fiber composite material and a method for preparing the same. The method includes providing a first carbon fiber layer and a second carbon fiber layer, binding a first surface of the first carbon fiber layer with the second carbon fiber layer to obtain a laminated article, wherein a resin containing carbon nanotubes is formed on the first surface or a second surface of the first carbon fiber layer and the carbon nanotubes have functional groups on the surface thereof; and shaping the laminated article.

US 5,554,430 discloses a boron/carbon fiber 1D laminate comprising a boron fiber layer and a carbon fiber layer having a balanced pair of carbon fiber plies embedded in a plastic resin matrix which has a coefficient of thermal expansion between ±0.54µm/m/°C. and a specific modulus greater than 8.9x10⁶ meter. A 2D boron/carbon fiber quasi-isotropic laminate has two sets of quasi-isotropic boron fiber plies, two sets of quasi-isotropic carbon fiber plies. The laminate has a Coefficient of Thermal Expansion between ±0.54 µm/m/°C. in two orthogonal directions and a specific modulus greater than 5.2x10⁶ meter in two orthogonal directions.
As such, there is a need for a new type of base plate that is capable of providing both the structural strength and thermal conductivity needed by different types of electronics packages while significantly reducing the weight of the base plate to enable the satellite to carry an increased payload.

### SUMMARY

Disclosed is a high thermal conductivity composite baseplate ("HTCCB") for use with an electronics package on a vehicle. The HTCCB includes a first boron and carbon fiber layer and a second boron and carbon fiber layer. Additionally, the HTCCB includes a carbon nanotube ("CNT") material attached between the first boron and carbon fiber layer and the second boron and carbon fiber layer where the CNT material includes a plurality of CNTs within the CNT material.

Other devices, apparatus, systems, methods, features and advantages of the disclosure will be or will become apparent to one with skill in the art upon examination of the following figures and detailed description. It is intended that all such additional systems, methods, features and advantages be included within this description, be within the scope of the disclosure, and be protected by the accompanying claims.

### BRIEF DESCRIPTION OF THE FIGURES

The disclosure may be better understood by referring to the following figures. The components in the figures are not necessarily to scale, emphasis instead being placed upon illustrating the principles of the disclosure. In the figures, like reference numerals designate corresponding parts throughout the different views.
FIG. 1 is a system diagram of an example of an implementation of a typical spacecraft payload.
FIG. 2 is a system diagram of an example of another implementation of a typical spacecraft payload.
FIG. 3A is a top perspective-view of an example of an implementation of an output multiplexer chassis.
FIG. 3B is a bottom perspective-view of the output multiplexer chassis shown in FIG. 3A.
FIG. 4 is a system diagram of an example of an implementation of a spacecraft payload utilizing a high thermal conductivity composite baseplate ("HTCCB") in accordance with various embodiments.
FIG. 5 is a block diagram of a front-view of an example of an implementation of the HTCCB shown in FIG. 4 in accordance with various embodiments.
FIG. 6 is a microscopic front-view of an example of an implementation of a composite CNT material between the first boron hybrid lamina and the second boron hybrid lamina with a plurality of continuous carbon nanotube ("CNTs") embedded in a CNT material in accordance with various embodiments.
Turning to FIG. 7, a block diagram side-view of an example of the implementation of the HTCCB, shown in FIGs. 4 and 5, in accordance with various embodiments.
FIG. 8A is a top perspective-view of an example of an implementation of an output multiplexer chassis utilizing a HTCCB, shown in FIGs. 4 through 7, in accordance with various embodiments.
FIG. 8B is a bottom perspective-view of the output multiplexer chassis utilizing the HTCCB shown in FIG. 8A.

### DETAILED DESCRIPTION

Disclosed is a high thermal conductivity composite baseplate ("HTCCB") for use with an electronics package on a vehicle. The HTCCB includes a first boron and carbon fiber layer and a second boron and carbon fiber layer. Additionally, the HTCCB includes an carbon nanotube ("CNT") material attached between the first boron and carbon fiber layer and the second boron and carbon fiber layer where the CNT material includes a plurality of CNTs within the CNT material.

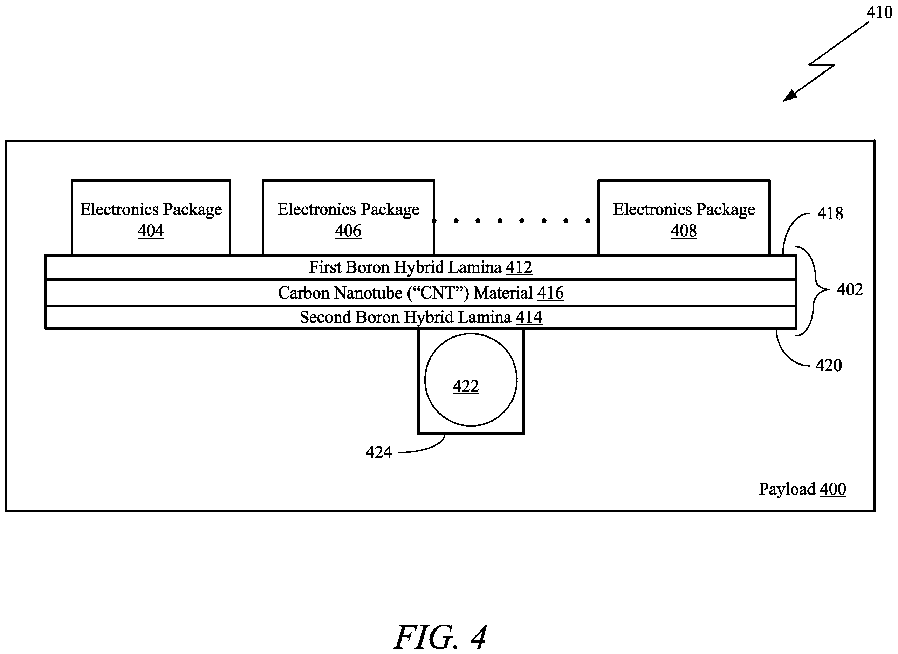

In FIG. 4, a system diagram of an example of an implementation of a spacecraft payload 400 utilizing an HTCCB 402 is shown in accordance with various embodiments. Similar to FIG. 2, in FIG. 4 the payload 400 may include a plurality of electronic packages 404, 406, and 408, respectively, that are physically connected and thermally coupled to the HTCCB 402 that acts as a structurally strong and thermally conductive composite material base plate. Again, these electronics packages 404, 406, and 408 may be active or passive devices but in general all the electronics packages 404, 406, and 408 generate heat that is transferred to the HTCCB 402 and subsequently transferred from the HTCCB 402, out of the payload 400 and generally to the external environment outside of the spacecraft 410.

In general, the HTCCB 402 is constructed of a composite material including a first boron hybrid lamina 412, a second boron hybrid lamina 414, and a CNT material 416 having a plurality of CNTs within the CNT material 416. In this example, the first and second boron hybrid lamina 412 and 414 are each a boron and carbon fiber layer including high strength boron fibers and high thermal conductivity pitch based carbon fibers running the length of the first and second boron hybrid laminas 412 and 414 parallel to first and second boron hybrid lamina surfaces 418 and 420, respectively.

The function of the HTCCB 402 is to structurally support the electronics packages 404, 406, and 408 and conduct dissipated heat from the electronics packages 404, 406, and 408 to one or more thermal heat-pipes that are thermally coupled to the HTCCB 402. In this example, one thermal heat-pipe 422, having a heat-pipe flange 424, is shown for the purpose of illustration but it is appreciated by those of ordinary skill in the art that there may be a plurality of heat-pipes thermally coupled to the HTCCB 402.

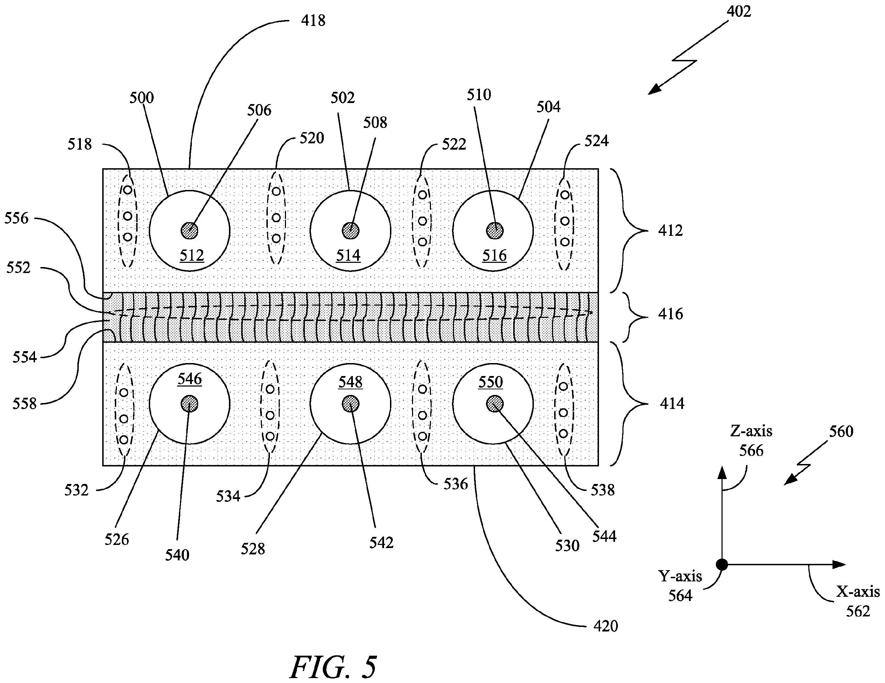

Turning to FIG. 5, a block diagram of a front-view of an example of an implementation of the HTCCB 402 of FIG. 4 is shown in accordance with various embodiments. In this example, the first boron hybrid lamina 412 includes a plurality boron fibers (also known as "boron filaments") 500, 502, and 504. The boron fibers are amorphous elemental boron products that manifest a combination of high strength and high modulus (i.e., high stiffness). Generally, amorphous elemental boron is produced by depositing elemental boron on an even tungsten wire substrate producing the boron fibers 500, 502, and 504 having fully borided (also known as "boronizing") tungsten cores (506, 508, and 510, respectively) that are encased in amorphous boron material 512, 514, and 516. In this example, the boron fibers 500, 502, and 504 may be approximately 0.01 cm (0.004 inches) in diameter.

The first boron hybrid lamina 412 includes a plurality of sets of carbon fibers 518, 520, 522, and 524 running parallel to the direction of the boron fibers 500, 502, and 504. In general, each carbon fiber (also generally known as "graphite fiber") of the plurality of carbon fibers 518, 520, 522, and 524 is a fiber composed mostly of carbon atoms. In general, each carbon fiber has carbon atoms that are bonded together in crystals that are more or less aligned parallel to the long axis of the carbon fiber. This crystal alignment results in the carbon fiber having a high strength-to-volume ratio resulting in high stiffness, high tensile strength, low weight, high chemical resistance, high temperature tolerance, and low thermal expansion. In this example, each carbon fiber may have a diameter of approximately 0.001 cm (0.0005 inches). Moreover, in this example, the HTCCB 402 may be approximately 0.43 cm (0.170 inches) thick.

In general, when the boron fibers are combined with the carbon fibers the resulting boron-graphite composite (i.e., the first boron hybrid lamina 412) properties improve because the boron fibers 500, 502, and 504 provide additional flexure strength to the plurality of carbon fibers 518, 520, 522, and 524. In this example, it is appreciated by one of ordinary skill in the art that only three boron fibers 500, 502, and 504 and four sets of carbon fibers 518, 520, 522, and 524 are shown in FIG. 5 for the convenience of illustration. It is also appreciated that in practice there may be thousands of boron fibers and carbon fibers without departing from scope of this disclosure. In this example, all of the boron fibers and carbon fibers run in a direction parallel (i.e., "in-plane") with the first surface 418 of the first boron hybrid lamina 412.

Similar to the first boron hybrid lamina 412, the second boron hybrid lamina 414 also includes a plurality boron fibers 526, 528, and 530 and a plurality of carbon fibers 532, 534, 536, and 538 running parallel to the direction of the boron fibers 520, 522, and 524. As with the first boron hybrid lamina 412, in the second boron hybrid lamina 414 the plurality boron fibers 526, 528, and 530 also include a corresponding plurality of fully borided tungsten cores (540, 542, and 544, respectively) encased in amorphous boron 546, 548, and 550.

In this example, again it is appreciated by of one ordinary skill in the art that only three boron fibers 526, 528, and 530 and four sets of carbon fibers 532, 534, 536, and 538 are shown in FIG. 5 for the convenience of illustration. It is also appreciated the that while both the first boron hybrid lamina 412 and the second boron hybrid lamina 414 are shown to have a relative thickness that is approximately only one boron fiber (either 512, 514, 516, 546, 548, or 550) thick, this is for ease of illustration and either the first boron hybrid lamina 412, the second boron hybrid lamina 414, or both may have a thickness that is multiple boron fibers thick. Moreover, it is also appreciated that in practice there may be thousands of boron fibers and carbon fibers without departing from scope of this disclosure. In this example, all of the boron fibers and carbon fibers run in an in-plane direction parallel with the second surface 420 of the second boron hybrid lamina 414. Utilizing an example coordinate system 560 having an *X*-axis 562, *Y*-axis 564, and *Z*-axis 566, the three boron fibers 526, 528, and 530 and four sets of carbon fibers 532, 534, 536, and 538 run in the *Y*-axis 564 parallel to an *X-Y* plane that cuts the HTCCB 402 along the *Z*-axis 566.

In this example, the CNT material 416 includes a plurality of CNTs 552 that may be optionally either embedded within a film adhesive 554 or with a non-adhesive material (that may be almost exclusively CNT material). In an example of the CNT material 416 including the film adhesive 554 may be, for example, an epoxy film. The film adhesive 554 may include the plurality of CNTs 552 oriented and aligned perpendicular to the bond lines 556 and 558 under the first boron hybrid lamina 412 and the second boron hybrid lamina 414.

In an alternative implementation, the CNT material 416 may not include any adhesive material (such as a film adhesive 554). In this implementation, both the first boron hybrid lamina 412 and the second boron hybrid lamina 414 may include, for example, a prepreggable ("prepreg") polymer resin. In this example, the CNT material 416 may be placed between both the first boron hybrid lamina 412 and the second boron hybrid lamina 414 and then cured such that part of the prepreg polymer resin flows from either the first boron hybrid lamina 412 and the second boron hybrid lamina 414, or both, into the CNT material 416 and hardens into a solid composite CNT material that includes the CNT material 416 and the polymer resin.

In this example, the CNT material 416 is shown including a plurality of CNTs 552 extending longitudinally from the first surface 556 of the first boron hybrid lamina 412 to a second surface 558 (which may be bond lines) of the second boron hybrid lamina 414 through the CNT material 416 (which may be a composite CNT material having adhesive material 554 that may be actual adhesive or prepreg polymer resin). In this example, each CNT of the plurality of CNTs 552 are oriented in an axial direction (i.e., along the *Z*-axis 566) between the first surface 556 to the second surface558. This axial direction may be perpendicular to the first surface 556 and the second surface 558 that are parallel to an *X-Y* plane along both the *X*-axis 562 and *Y-*axis 564. Additionally, the plurality of CNTs 552 may be continuous between the first surface 556 and the second surface 558 to a point where the plurality of CNTs 552 may be in physical contact with the first boron hybrid lamina 412 and the second boron hybrid lamina 414. In this example, the plurality of CNTs 552 may act as a thermal bridge from the first boron hybrid lamina 412 and the second boron hybrid lamina 414. In this case, the plurality of CNTs 552 may act as a substantial thermal bridge through the CNT material 416. In the example of CNT material 416 including an adhesive 554, the plurality of CNTs 552 form a parallel heat conduction path from the first boron hybrid lamina 412 and the second boron hybrid lamina 414 that is in parallel with heat conduction path through the adhesive 554. It is appreciated by those of ordinary skill in the art that CNTs have extremely high thermal conductivity along the CNT longitudinal axis as compared to an adhesive 554 such as, for example, an epoxy adhesive. As an example, the plurality of CNTs 552 and adhesive 554 (whether actual adhesive or cured prepreg polymer resin) in the CNT material 416 may be approximately 10 micrometers thick.

It is appreciate by those of ordinary skill in the art that the individual CNTs of the CNT material 416 are shown as being oriented approximately in parallel in an approximately perpendicular (i.e., along the Z-axis 566) to the first boron hybrid lamina 412 and the second boron hybrid lamina 414, where the individual CNTs are shown as not be perfectly straight to illustrate that in general the individual CNTs will be approximately straight as they extend perpendicularly between the first boron hybrid lamina 412 and the second boron hybrid lamina 414.

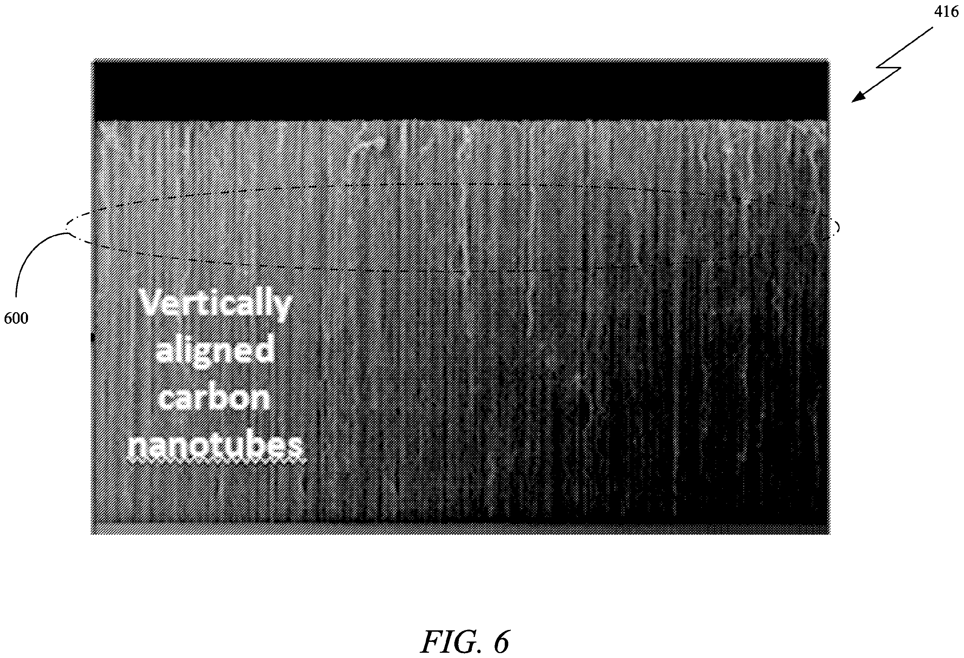

In FIG. 6, a microscopic front-view of an example of an implementation of a CNT material 416 between the first boron hybrid lamina 412 and the second boron hybrid lamina 414 is shown with the plurality of CNTs 600 embedded in the CNT material 416 in accordance with various embodiments.

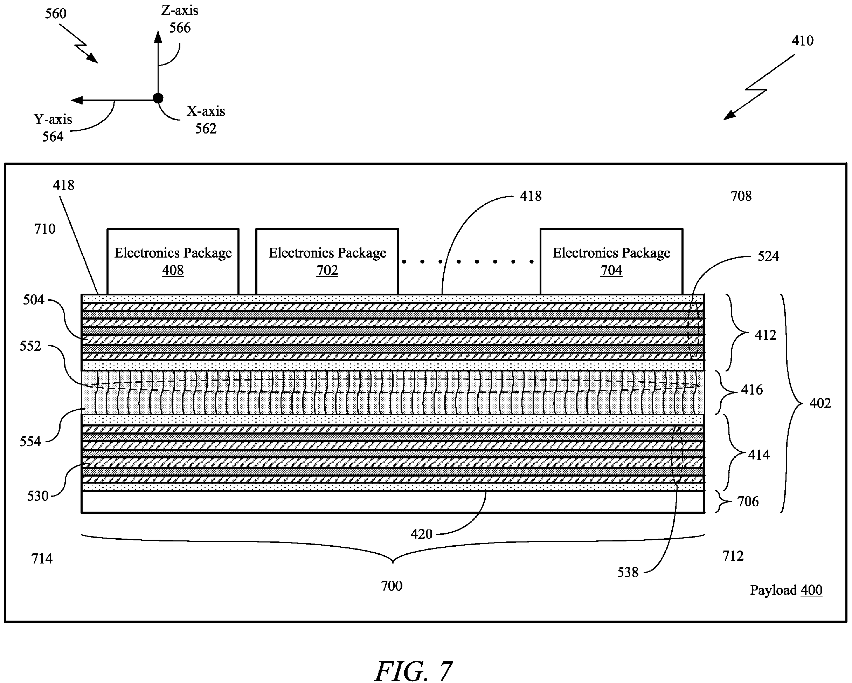

Turning to FIG. 7, a block diagram of a side-view of an example of the implementation of the HTCCB 402, of FIGs. 4 and 5, is shown in accordance with various embodiments. In this view, the HTCCB 402 is shown to have a length 700 that may accommodate additional electronic packages 702 and 704 on the first boron hybrid lamina 412 surface 418. The length 700 runs along the in-plane direction of the HTCCB 402 along the *Y*-axis 564 (utilizing the same coordinate system shown in FIG. 5).

It is appreciated that while only two additional electronic packages 702 and 704 are shown, there could be a larger number of electronic packages without departing from the spirit of the present disclosure. Moreover, the thermal heat-pipe 706 is shown attached to second boron hybrid lamina 414 surface 420 and running along the length 700 of the HTCCB 402 along *Y*-axis 564. However, it is appreciated that the thermal heat-pipe 706 may alternatively run perpendicular (i.e., along the X-axis 562) to the length 700 of the HTCCB 402 without departing from the spirit of the disclosure.

In this example, the first boron hybrid lamina 412 is shown having the boron fiber 504 (shown in FIG. 5) and the set of carbon fibers 524 running in the in-plane direction (i.e., the *Y*-axis 564) along the length 700 of the HTCCB 402. Similarly, the second boron hybrid lamina 414 is shown having the boron fiber 530 and set of carbon fibers 538 running in the in-plane direction (i.e., the *Y*-axis 564) along the length 700 of the HTCCB 402.

As stated earlier, in this example, the plurality of CNTs 552 are shown extending longitudinally (i.e., along the *Z*-axis 566) from the first boron hybrid lamina 412 to the second boron hybrid lamina 414 through the CNT material 416 where each CNT is oriented in an axial direction (i.e., along the *Z*-axis 566) between the first boron hybrid lamina 412 to the second boron hybrid lamina 414. Again the CNT material 416 may include a material 554 that may be adhesive or prepreg polymer resin.

In an example of thermal operation, the first boron hybrid lamina 412 and second boron hybrid lamina 414 perform in-plane (i.e., along the *Y*-axis 564) thermal conduction along the length 700 of the HTCCB 402 while maintaining a high strength and rigidity. While, the plurality of CNTs 552 may act as a thermal bridge from the first boron hybrid lamina 412 and the second boron hybrid lamina 414 transferring heat in a direction (i.e., the *Z*-axis 566) that is approximately perpendicular to the in-plane (i.e., along the *Y*-axis 564) thermal conduction along the first boron hybrid lamina 412 and the second boron hybrid lamina 414.

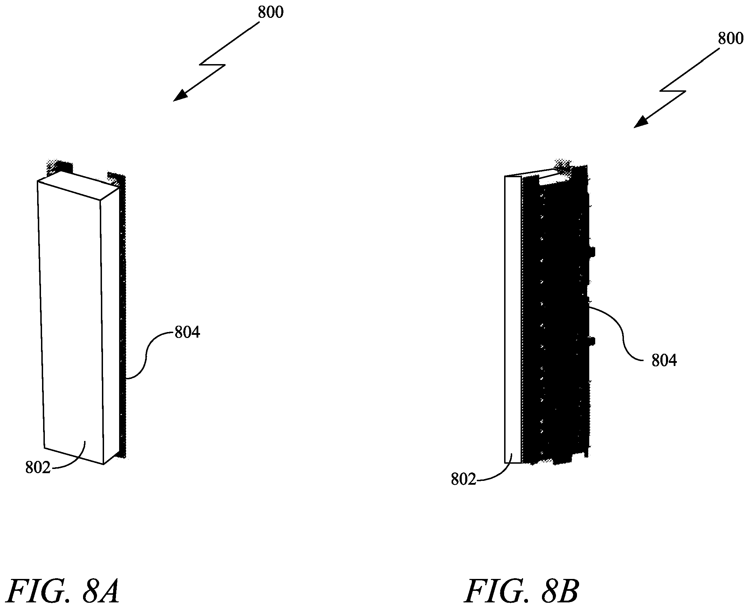

In FIG. 8A, a top perspective-view of an example of an implementation of an output multiplexer chassis utilizing a HTCCB 800, shown in FIGs. 4 through 7, is shown in accordance with various embodiments. Similarly in FIG. 8B, a bottom perspective-view of the output multiplexer chassis utilizing a HTCCB 800 is shown. The output multiplexer chassis 800 may include an output multiplexer 802 and a HTCCB 804 connected to the output multiplexer 802. The output multiplexer 802 is an example of an electronics package as described in FIGs. 4 and 7 and it is appreciated by of ordinary skill in the art that the output multiplexer 802 is only an example of an electronics package and not meant to be limiting the different potential examples of the electronics package. In this example, the output multiplexer 802 may be a passive microwave or millimeter waveguide network having a plurality of metallic waveguide runs and couplers that radiate heat when power is transmitted through the network. In general, the output multiplexer 802 needs to be structurally supported and as such the HTCCB 804 provides the structural support that the output multiplexer 802 physically needs. Additionally, since the output multiplexer 802 generates and dissipates a significant amount of heat, the HTCCB 804 is capable of transferring the heat generated by the output multiplexer 802 to a heat-pipe (not shown) that is capable of transferring the heat away from the payload. In this example, the heat-pipe may be located at a long-edge of the HTCCB 804. In this example, the HTCCB 804 may weigh approximately 6.3 pounds which is approximately 4.2 pounds less than the known base plate 304 shown in FIG. 3. As such, the HTCCB 804 provides strength, rigidity, and thermal conduction and at significate weight saving over known base plates.

It will be understood that various aspects or details of the disclosure may be changed without departing from the scope of the disclosure. It is not exhaustive and does not limit the claimed disclosures to the precise form disclosed. Furthermore, the foregoing description is for the purpose of illustration only, and not for the purpose of limitation. Modifications and variations are possible in light of the above description or may be acquired from practicing the disclosure. The claims and their equivalents define the scope of the disclosure.

## Claims

1. A high thermal conductivity composite baseplate ("HTCCB ") (402) for use with an electronics package (404. 406, 408) on a vehicle, the HTCCB comprising:
a first boron and carbon fiber layer (412);
a second boron and carbon fiber layer (414);
an carbon nanotube ("CNT") material (416) attached between the first boron and carbon fiber layer to the second boron and carbon fiber layer,
wherein the CNT material includes a plurality of CNTs (552), the plurality of CNTs (552) being oriented in an axial direction between the first boron and carbon fiber layer (412) and the second boron and carbon fiber layer (414).

2. The HTCCB of claim 1, wherein the plurality of CNTs (552) are continuous between the first boron and carbon fiber layer (412) and the second boron and carbon fiber layer (414).

3. The HTCCB of claim 1 or claim 2, wherein the plurality of CNTs (552) are in physical contact with the first boron and carbon fiber layer (412) and the second boron and carbon fiber layer (414) creating a bridge from the first boron and carbon fiber layer and the second boron and carbon fiber layer.

4. The HTCCB of any one of claims 1 to 3, wherein the plurality of CNTs (552) create a substantial bridge through the CNT material.

5. The HTCCB of any one of claims 1 to 4, wherein the plurality of CNTs (552) form a parallel heat conduction path from the first boron and carbon fiber layer (412) to the second boron and carbon fiber layer (414), which is in parallel with a heat conduction path from the first boron and carbon fiber layer to the second boron and carbon fiber layer.

6. The HTCCB of any one of claims 1 to 5, wherein the plurality of CNTs (552) are arranged perpendicular to an inner surface (556) of the first boron and carbon fiber layer and an inner surface (558) of the second boron and carbon fiber layer.

7. The HTCCB of any one of claims 1 to 6, wherein the CNT material (416) includes an epoxy film disposed between the first boron and carbon fiber layer and an inner surface of the second boron and carbon fiber layer.

8. The HTCCB of any one of claims 1 to 7, wherein the CNT material (416) is approximately 10 micrometers thick.

9. The HTCCB of any one of claims 1 to 8, wherein the plurality of CNTs (552) are configured to transfer the maximum amount of heat from the first boron and carbon fiber layer (412) and an inner surface (558) of the second boron and carbon fiber layer.

10. The HTCCB of any one of claims 1 to 9,
wherein the first boron and carbon fiber layer (412) includes a plurality of boron fibers (500, 502, 504) and a plurality of carbon fibers (518, 520, 522, 524),
wherein a diameter of a boron fiber of the plurality of boron fibers is substantially greater than a diameter of a carbon fiber or the plurality of carbon fibers.

11. The HTCCB of any one of claims 1 to 10, wherein the diameter of the boron fiber is 0.01 cm (0.004 inches).

12. The HTCCB of any one of claims 1 to 11, wherein the diameter of the carbon fiber is 0.001 cm (0.0005 inches).

13. An output multiplexer chassis (800) comprising:
an output multiplexer (802); and
a high thermal conductivity composite baseplate ("HTCCB") according to any of claims 1 to 12.

## Patentansprüche

1. Basisplatte aus Verbundwerkstoff mit hoher Wärmeleitfähigkeit (high thermal conductivity composite baseplate, HTCCB) (402) zur Verwendung mit einem Elektronikgehäuse (404, 406, 408) an einem Fahrzeug, wobei die HTCCB umfasst:
eine erste Bor- und Kohlefaserschicht (412);
eine zweite Bor- und Kohlefaserschicht (414);
ein Kohlenstoff-Nanoröhrchen- (carbon nanotube, CNT) Material (416), das zwischen der ersten Bor- und Kohlefaserschicht und der zweiten Bor- und Kohlefaserschicht befestigt ist, wobei das CNT-Material eine Vielzahl von CNTs (552) aufweist, wobei die Vielzahl von CNTs (552) in einer axialen Richtung zwischen der ersten Bor- und Kohlefaserschicht (412) und der zweiten Bor- und Kohlefaserschicht (414) ausgerichtet ist.

2. HTCCB nach Anspruch 1, in der die Vielzahl von CNTs (552) zwischen der ersten Bor- und Kohlefaserschicht (412) und der zweiten Bor- und Kohlefaserschicht (414) kontinuierlich ist.

3. HTCCB nach Anspruch 1 oder Anspruch 2, bei der die Vielzahl von CNTs (552) in physischem Kontakt mit der ersten Bor- und Kohlefaserschicht (412) und der zweiten Bor- und Kohlefaserschicht (414) steht und eine Brücke aus der ersten Bor- und Kohlefaserschicht und der zweiten Bor- und Kohlefaserschicht bildet.

4. HTCCB nach einem der Ansprüche 1 bis 3, bei der die Vielzahl der CNTs (552) eine massive Brücke durch das CNT-Material bildet.

5. HTCCB nach einem der Ansprüche 1 bis 4, bei der die Vielzahl von CNTs (552) einen parallelen Wärmeleitweg von der ersten Bor- und Kohlefaserschicht (412) zur zweiten Bor- und Kohlefaserschicht (414) bildet, der parallel zu einem Wärmeleitweg von der ersten Bor- und Kohlefaserschicht zur zweiten Bor- und Kohlefaserschicht ist.

6. HTCCB nach einem der Ansprüche 1 bis 5, bei der die Vielzahl von CNTs (552) senkrecht zu einer Innenfläche (556) der ersten Bor- und Kohlefaserschicht und einer Innenfläche (558) der zweiten Bor- und Kohlefaserschicht angeordnet ist.

7. HTCCB nach einem der Ansprüche 1 bis 6, bei der das CNT-Material (416) eine Epoxidfolie umfasst, die zwischen der ersten Bor- und Kohlefaserschicht und einer Innenfläche der zweiten Bor- und Kohlefaserschicht angeordnet ist.

8. HTCCB nach einem der Ansprüche 1 bis 7, bei der das CNT-Material (416) etwa 10 Mikrometer dick ist.

9. HTCCB nach einem der Ansprüche 1 bis 8, bei der die Vielzahl von CNTs (552) konfiguriert ist, um die maximale Wärmemenge von der ersten Bor- und Kohlefaserschicht (412) und einer Innenfläche (558) der zweiten Bor- und Kohlefaserschicht zu übertragen.

10. HTCCB nach einem der Ansprüche 1 bis 9,
bei der die erste Bor- und Kohlefaserschicht (412) eine Vielzahl von Borfasern (500, 502, 504) und eine Vielzahl von Kohlenstofffasern (518, 520, 522, 524) aufweist,
wobei ein Durchmesser einer Borfaser der Vielzahl von Borfasern deutlich größer ist als ein Durchmesser einer Kohlefaser oder der Vielzahl von Kohlefasern.

11. HTCCB nach einem der Ansprüche 1 bis 10, bei der der Durchmesser der Borfaser 0,01 cm (0,004 Zoll) beträgt.

12. HTCCB nach einem der Ansprüche 1 bis 11, bei dem der Durchmesser der Kohlefaser 0,001 cm (0,0005 Zoll) beträgt.

13. Ausgangsmultiplexer-Chassis (800), umfassend:
einen Ausgabemultiplexer (802); und
eine hochwärmeleitende Verbundbasisplatte ("HTCCB") nach einem der Ansprüche 1 bis 12.

## Revendications

1. Plaque de base composite à haute conductivité thermique (« HTCCB ») (402) destinée à être utilisée avec un boîtier électronique (404. 406, 408) sur un véhicule, la HTCCB comprenant :
une première couche de fibres de bore et de carbone (412) ;
une seconde couche de fibres de bore et de carbone (414) ;
un matériau à base de nanotubes de carbone (« CNT ») (416) fixé entre la première couche de fibres de bore et de carbone et la seconde couche de fibres de bore et de carbone,
dans laquelle le matériau CNT comprend une pluralité de CNT (552), la pluralité de CNT (552) étant orientée dans une direction axiale entre la première couche de fibres de bore et de carbone (412) et la seconde couche de fibres de bore et de carbone (414).

2. HTCCB selon la revendication 1, dans laquelle la pluralité de CNT (552) est continue entre la première couche de fibres de bore et de carbone (412) et la seconde couche de fibres de bore et de carbone (414).

3. HTCCB selon la revendication 1 ou la revendication 2, dans laquelle la pluralité de CNT (552) est en contact physique avec la première couche de fibres de bore et de carbone (412) et la seconde couche de fibres de bore et de carbone (414) créant un pont allant de la première couche de fibres de bore et de carbone et la seconde couche de fibres de bore et de carbone.

4. HTCCB selon l'une quelconque des revendications 1 à 3, dans laquelle la pluralité de CNT (552) crée un pont substantiel à travers le matériau CNT.

5. HTCCB selon l'une quelconque des revendications 1 à 4, dans laquelle la pluralité de CNT (552) forme un trajet de conduction thermique parallèle allant de la première couche de fibres de bore et de carbone (412) à la seconde couche de fibres de bore et de carbone (414), qui est en parallèle avec un trajet de conduction thermique allant de la première couche de fibres de bore et de carbone à la seconde couche de fibres de bore et de carbone.

6. HTCCB selon l'une quelconque des revendications 1 à 5, dans laquelle la pluralité de CNT (552) est disposée perpendiculairement à une surface intérieure (556) de la première couche de fibres de bore et de carbone et à une surface intérieure (558) de la seconde couche de fibres de bore et de carbone.

7. HTCCB selon l'une quelconque des revendications 1 à 6, dans laquelle le matériau CNT (416) comprend un film époxy disposé entre la première couche de fibres de bore et de carbone et une surface intérieure de la seconde couche de fibre de bores et de carbone.

8. HTCCB selon l'une quelconque des revendications 1 à 7, dans laquelle le matériau CNT (416) a une épaisseur d'environ 10 micromètres.

9. HTCCB selon l'une quelconque des revendications 1 à 8, dans laquelle la pluralité de CNT (552) est configurée pour transférer la quantité maximale de chaleur de la première couche de fibres de bore et de carbone (412) à une surface intérieure (558) de la seconde et couche de fibres de bore et de carbone.

10. HTCCB selon l'une quelconque des revendications 1 à 9,
dans laquelle la première couche de fibres de bore et de carbone (412) comprend une pluralité de fibres de bore (500, 502, 504) et une pluralité de fibres de carbone (518, 520, 522, 524),
dans laquelle un diamètre d'une fibre de bore de la pluralité de fibres de bore est sensiblement supérieur à un diamètre d'une fibre de carbone de la pluralité de fibres de carbone.

11. HTCCB selon l'une quelconque des revendications 1 à 10, dans laquelle le diamètre de la fibre de bore est de 0,01 cm (0,004 pouce).

12. HTCCB selon l'une quelconque des revendications 1 à 11, dans laquelle le diamètre de la fibre de carbone est de 0,001 cm (0,0005 pouce).

13. Châssis de multiplexeur de sortie (800) comprenant :
un multiplexeur de sortie (802) ; et
une plaque de base composite à haute conductivité thermique (« HTCCB ») selon l'une quelconque des revendications 1 à 12.
